# EUROPEAN PATENT APPLICATION

(11) **EP 4 117 399 A1**
(43) Date of publication of application: **11.01.2023**
(21) Application number: 22181070.8
(22) Date of filing: 24.06.2022
(51) Int. Cl.: H05K 1/11, H05K 1/14, H05K 3/36, H01R 12/83

(54) **CIRCUIT BOARD ASSEMBLY**

(30) Priority: 07.07.2021 CN 202110766939
(71) Applicant: Huawei Technologies Co., Ltd., Shenzhen, Guangdong 518129, (CN)
(72) Inventor: CHEN, Gang, Shenzhen, 518129 (CN); ZHENG, Yufeng, Shenzhen, 518129 (CN); LI, Zhe, Shenzhen, 518129 (CN); GUO, Zhigang, Shenzhen, 518129 (CN); ZHANG, Xiaoliu, Shenzhen, 518129 (CN)
(74) Representative: Gill Jennings & Every LLP

(57) **Abstract**

This application relates to a circuit board assembly. The circuit board assembly includes: a first circuit board (1), where the first circuit board (1) is connected to a connector (2); and a second circuit board (3), where a first connecting portion (311) is disposed on the second circuit board (3), and the first connecting portion (311) is electrically connected to the connector (2). The second circuit board (3) includes a top surface (31) and a side surface (32), and the top surface (31) intersects and is perpendicular to the side surface (32). The first connecting portion (311) is disposed on the top surface (31), and extends towards the side surface (32). In this application, the top surface (31) intersects and is perpendicular to the side surface (32), to improve stability of connection between the connector (2) and the first connecting portion (311), and improve working stability of the second circuit board (3), so as to improve working performance of the circuit board assembly and improve user experience.

## Description

### TECHNICAL FIELD

This application relates to the field of circuit board technologies, and in particular, to a circuit board assembly.

### BACKGROUND

With miniaturization and diversification of functions of terminal products, a user has an increasingly high requirement for a capacity and density of a circuit board. To meet the requirement of the user, a plurality of circuit boards are usually used to form a circuit board assembly. Usually, when a plurality of circuit boards form a circuit board assembly, the plurality of circuit boards are connected by using a connector. In the plurality of circuit boards, a bottom board is connected to the connector, and an electrically connecting portion is disposed on the other circuit boards. The electrically connecting portion can be electrically connected to a contact of the connector, to implement electrical connection of the plurality of circuit boards. However, in an assembly process and a working process of the circuit board assembly, reliability of connection between the electrically connecting portion and the contact of the connector is relatively low, resulting in relatively low reliability of the electrical connection of the plurality of circuit boards. Consequently, there is low working stability of the circuit board assembly and poor user experience.

### SUMMARY

This application provides a circuit board assembly, to improve working stability of the circuit board assembly and improve user experience.

This application provides a circuit board assembly. The circuit board assembly includes:
a first circuit board, where the first circuit board is connected to a connector; and
a second circuit board, where a first connecting portion is disposed on the second circuit board, and the first connecting portion is electrically connected to the connector.

The second circuit board includes a top surface and a side surface, and the top surface intersects and is perpendicular to the side surface.

The first connecting portion is disposed on the top surface, and extends towards the side surface.

In this application, the top surface intersects and is perpendicular to the side surface, to improve stability of connection between the connector and the first connecting portion, and improve working stability of the second circuit board, so as to improve working performance of the circuit board assembly and improve user experience.

In a possible design, the connector includes a slot, and a part of the second circuit board can be inserted into the slot;
the slot includes a first sidewall, a first contact is disposed on the first sidewall, and the first contact is electrically connected to the first connecting portion; and
a distance between the first contact and a tail end of the first connecting portion is a1, and a1>0.

In this application, when the distance a1 between the first contact and the tail end of the first connecting portion is greater than 0, reliability of connection between the first contact and the first connecting portion can be improved, and service performance of the second circuit board can be improved, to improve service performance and working stability of the circuit board assembly.

In a possible design, a1≥0.51 mm.

In this application, a1≥0.51 mm, and therefore when a processing error and an assembly error of the connector and the second circuit board are not considered, a requirement on precision of a processing size of a part such as the connector and the second circuit board is lowered, and processing difficulty is reduced, to reduce manufacturing costs.

In a possible design, a distance between a tail end of the first connecting portion and the side surface is a4, and a4≤0.2 mm.

In this application, a4≤0.2 mm, so that a risk that the first contact and the first connecting portion cannot be connected in a mounting or transportation process is reduced, to improve service performance of the second circuit board, so as to improve service performance and working stability of the circuit board assembly.

In a possible design, a tail end of the first connecting portion is flush with the side surface.

In this application, the first connecting portion is flush with the side surface, to improve stability of connection between the connector and the first connecting portion, and reduce processing precision of a part such as the second circuit board and the connector, so as to reduce manufacturing costs.

In a possible design, the second circuit board further includes a bottom surface disposed opposite to the top surface, and the bottom surface is connected to the side surface by using a first inclined surface; and
a second connecting portion is disposed on the bottom surface, and the second connecting portion is electrically connected to the connector.

In this application, the first inclined surface is disposed, so that strength of the second circuit board and the connector can be improved, and a service life of each of the second circuit board and the connector can be prolonged, to improve service performance of the circuit board assembly, and improve user experience.

In a possible design, the second circuit board further includes a bottom surface disposed opposite to the top surface, and the bottom surface intersects and is perpendicular to the side surface; and
a second connecting portion connected to the connector is disposed on the bottom surface, and the second connecting portion extends towards the side surface.

In this application, the second connecting portion extends towards the side surface, so that a size of the second connecting portion is increased, to improve stability of connection between the connector and the second connecting portion, and improve working stability of the second circuit board, so as to improve working performance of the circuit board assembly and improve user experience.

In a possible design, a tail end of the second connecting portion is flush with the side surface.

In this application, the tail end of the second connecting portion is flush with the side surface, to further improve the stability of the connection between the connector and the second connecting portion, and increase an offset of the second circuit board, so as to reduce manufacturing costs.

In a possible design, the connector includes the slot, the slot includes the first sidewall and a second sidewall that are disposed opposite to each other, the first contact is disposed on the first sidewall, and a second contact is disposed on the second sidewall;
the second circuit board further includes a bottom surface disposed opposite to the top surface, a second connecting portion is disposed on the bottom surface, the first contact is electrically connected to the first connecting portion, and the second contact is electrically connected to the second connecting portion; and
a part of the second circuit board can be obliquely inserted into the slot from top to bottom, the distance between the tail end of the first connecting portion and the side surface is a4, a distance between a tail end of the second connecting portion and the side surface is a5, and a4≤a5.

In this application, a4≤a5, to improve reliability of connection between the second circuit board and the connector, and reduce processing costs of the second connecting portion, so as to improve user experience.

In a possible design, the second contact is located outside the first contact, the distance between the first contact and the tail end of the first connecting portion is a1, a distance between the second contact and the tail end of the second connecting portion is a2, and a1≤a2.

In this application, a1≤a2, to improve stability of connection between the second contact and the second connecting portion, so as to improve working stability and service performance of the second circuit board.

In a possible design, a concave portion is disposed on the second sidewall.

In this application, the concave portion is disposed on the second sidewall, to facilitate mounting of the second circuit board, improve accuracy of mounting the second circuit board, and prolong a service life of each of the second circuit board and the connector, so as to improve user experience.

In a possible design, a second inclined surface and a third inclined surface are disposed at an opening of the slot, and the second inclined surface and the third inclined surface are configured to guide a part of the second circuit board into the slot.

In this application, the second inclined surface and the third inclined surface are disposed, to simplify an operation of mounting the second circuit board, and prolong a service life of the second circuit board.

In a possible design, an end that is of the second circuit board and that is far away from the connector is connected to the first circuit board by using a stud.

In this application, the stud is disposed, to improve stability of mounting the second circuit board, and save space of the first circuit board, so that utilization of the first circuit board is improved, to improve working performance of the first circuit board, and improve user experience.

In a possible design, the stud is attached to the first circuit board.

In this application, the stud is attached to the first circuit board, so that an operation in a process of mounting the stud can be simplified, and a process required for mounting the stud can be reduced, to reduce manufacturing costs of the circuit board assembly.

It should be understood that the foregoing general description and the following detailed description are merely examples, and cannot limit this application.

### BRIEF DESCRIPTION OF DRAWINGS

FIG. 1 is a schematic diagram of a structure of a circuit board assembly in the conventional technology:
FIG. 2 is an enlarged diagram of a part I in FIG. 1;
FIG. 3 is a schematic diagram of a process of mounting a first circuit board and a connector according to this application;
FIG. 4 is a schematic diagram of a partial structure of a circuit board assembly at a position of connection between a second circuit board and a connector in an embodiment according to this application;
FIG. 5 is a schematic diagram of a structure of the second circuit board in FIG. 4 in an embodiment, where a tail end of a first connecting portion is flush with a side surface of the second circuit board;
FIG. 6 is a schematic diagram of a structure of the second circuit board in FIG. 4 in another embodiment, where there is a distance between a tail end of a first connecting portion and a side surface of the second circuit board;
FIG. 7 is a schematic diagram of a structure of the second circuit board in FIG. 4 in another embodiment, where a tail end of a first connecting portion is flush with a side surface of the second circuit board, and a tail end of a second connecting portion is flush with the side surface of the second circuit board;
FIG. 8 is a schematic diagram of a partial structure of a circuit board assembly at a position of connection between a second circuit board and a connector in another embodiment according to this application;
FIG. 9 is a schematic diagram of a structure of the connector in FIG. 4 and FIG. 8;
FIG. 10 is a schematic diagram of a structure of a circuit board assembly according to this application; and
FIG. 11 is a sectional view of a stud in FIG. 10.

Reference numerals:
1': First circuit board;
2': Connector;
   211a': First contact;
   212a': Second contact;
3': Third circuit board;
   311': First connecting portion;
   331': Second connecting portion;
1: First circuit board;
2: Connector;
   21: Slot;
   211: First sidewall;
      211a: First contact;
   212: Second sidewall;
      212a: Second contact;
      212b: Concave portion;
   213: Bottom wall;
   214: Second inclined surface;
   215: Third inclined surface;
3: Second circuit board;
   31: Top surface;
      311: First connecting portion;
   32: Side surface
   33: Bottom surface;
      331: Second connecting portion;
   34: First inclined surface;
4: Stud;
   41: Boss; and
5: Fastener.

The accompanying drawings herein are incorporated into the specification and constitute a part of the specification, show embodiments conforming to this application, and are used together with the specification to explain a principle of this application.

### DESCRIPTION OF EMBODIMENTS

To better understand the technical solutions of this application, the following describes embodiments of this application in detail with reference to the accompanying drawings.

In a specific embodiment, the following further describes this application in detail by using specific embodiments and with reference to the accompanying drawings.

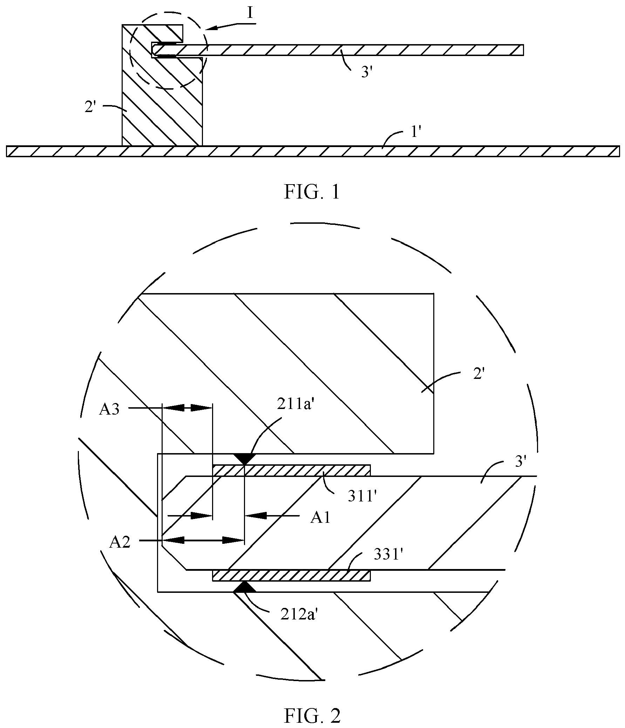

With miniaturization and diversification of functions of terminal products, an increasingly large quantity of parts are mounted on a circuit board, and therefore the circuit board has an increasingly large capacity and increasingly high component density. Usually, to ensure service performance of the circuit board and reduce the density of the circuit board, a plurality of circuit boards may be electrically connected to form a circuit board assembly. Specifically, as shown in FIG. 1, the circuit board assembly includes a first circuit board 1', a second circuit board 3', and a connector 2'. The connector 2' is mounted on the first circuit board 1', and the second circuit board 3' is electrically connected to the connector 2', so that the first circuit board is electrically connected to the second circuit board. As shown in FIG. 2, the connector 2' includes a first contact 211a' and a second contact 212a' that are disposed opposite to each other, and the second circuit board 3' includes a first connecting portion 311' and a second connecting portion 331' that are disposed opposite to each other. When the second circuit board 3' is mounted into the connector 2', a part of the second circuit board 3' is inserted into a slot of the connector, the first contact 211a' is electrically connected to the first connecting portion 311', and the second contact 212a' is electrically connected to the second connecting portion 331'.

Connection between the first contact 211a' and the first connecting portion 311' is used as an example. A distance between the first contact 211a' and a tail end of the first connecting portion 311' is A1, a distance between the first contact 211a' and a tail end of the second circuit board 3' is A2, a distance between the tail end of the first connecting portion 311' and the tail end of the second circuit board 3' is A3, and A2=A1+A3. A larger value of A3 indicates a smaller value of A1. When A1 (the distance between the first contact 211a' and the tail end of the first connecting portion 311') is an excessively small value, the first contact 211a' is in contact with the first connecting portion 311' in an excessively small range, and consequently there is unstable electrical connection between the second circuit board 3' and the connector 2', and normal use of the circuit board assembly is affected, which degrades user experience.

To resolve this technical problem, the distance A1 between the first contact 211a' and the tail end of the first connecting portion 311' needs to be increased, and this may be specifically implemented by decreasing the distance A3 between the tail end of the first connecting portion 311' and the tail end of the second circuit board.

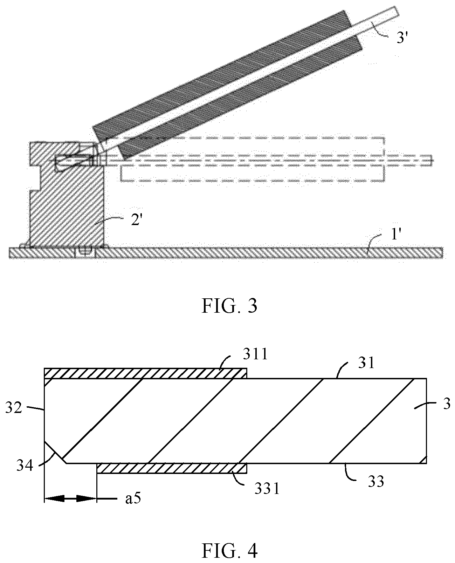

Specifically, the embodiments provide a circuit board assembly. As shown in FIG. 3, the circuit board assembly includes a first circuit board 1 and a second circuit board 3. The first circuit board 1 is connected to a connector 2. As shown in FIG. 4, FIG. 5, and FIG. 6, a first connecting portion 311 is disposed on the second circuit board 3, and the first connecting portion 311 is connected to the connector 2. The second circuit board 3 includes a top surface 31 and a side surface 32, and the top surface 31 intersects and is perpendicular to the side surface 32. The first connecting portion 311 is disposed on the top surface 31, and extends towards the side surface 32.

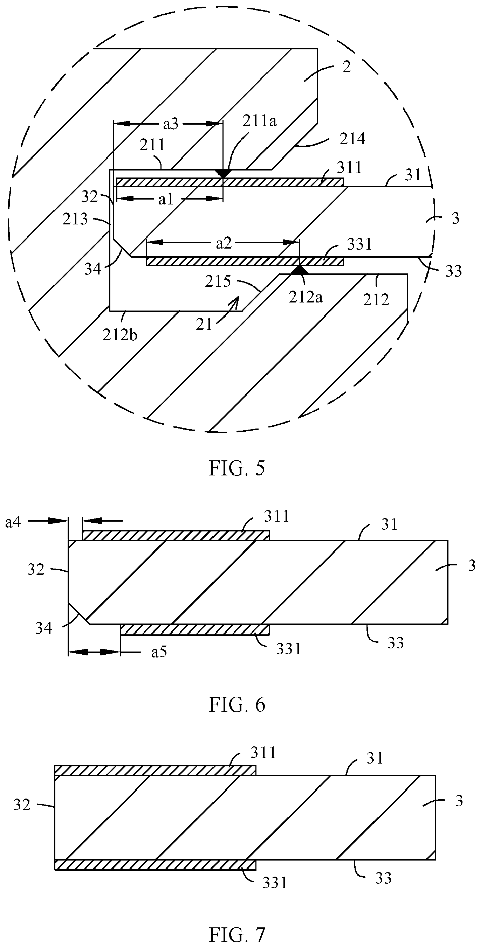

As shown in FIG. 5, a distance between a first contact 211a and a tail end of the first connecting portion 311 is a1, a distance between the first contact 211a and a tail end of the second circuit board 3 is a3, a distance between the tail end of the first connecting portion 311 and the tail end of the second circuit board 3 is a4, and a3=a1+a4. The tail end of the first connecting portion 311 is an end that is of the first connecting portion 311 and that is located in a slot of the connector 2. The tail end of the second circuit board 3 is an end that is of the second circuit board 3 and that is located in the slot of the connector 2.

In this embodiment, the top surface 31 intersects and is perpendicular to the side surface 32, so that an area of the top surface 31 is increased, to increase an area in which the first connecting portion 311 can be mounted, and facilitate mounting of the first connecting portion 311. In addition, the first connecting portion 311 extends towards the side surface 32, so that a size of the first connecting portion 311 is increased, and the distance a4 between the tail end of the first connecting portion 311 and the tail end of the second circuit board 3 is decreased, to increase the distance a1 between the first contact 211a and the tail end of the first connecting portion 311, in other words, to increase a range in which the connector 2 is electrically connected to the first connecting portion 311, and reduce a risk that the connector 2 is not in contact with the first connecting portion 311 due to the fact that a position of the second circuit board 3 deviates in a mounting or transportation process, so as to improve stability of connection between the connector 2 and the first connecting portion 311, and improve working stability of the second circuit board 3. In this way, working performance of the circuit board assembly is improved, and user experience is improved.

Specifically, as shown in FIG. 5, the connector 2 includes the slot 21, and a part of the second circuit board 3 can be inserted into the slot 21. The slot 21 includes a first sidewall 211. The first contact 211a is disposed on the first sidewall 211. The first contact 211a is electrically connected to the first connecting portion 311. The distance a1 between the first contact 211a and the tail end of the first connecting portion 311 is greater than 0 mm. For example, a1 may be specifically 0.3 mm, 0.4 mm, or 0.5 mm.

In this embodiment, the slot 21 is disposed in the connector 2, and the slot 21 can restrict the second circuit board 3 to moving in a height direction of the connector 2, to implement connection between the second circuit board 3 and the connector 2. The first contact 211a is disposed on the first sidewall 211 of the slot 21, so that the second circuit board 3 is electrically connected to the connector 2 while the slot 21 limits a position of the second circuit board 3, to simplify a structure of the connector 2 and reduce manufacturing costs of the connector 2. There is the distance a1 between the first contact 211a and the tail end of the first connecting portion 311, so that a range in which the first contact 211a is connected to the first connecting portion 311 can be increased, and a case in which the first circuit board 1 fails to be connected to the second circuit board 3 because during mounting of the second circuit board 3 into the slot 21 and in a working process of the circuit board assembly, the first contact 211a cannot be connected to the first connecting portion 311 due to impact of a processing error and an assembly error can be avoided, to improve reliability of connection between the first contact 211a and the first connecting portion 311, and improve service performance of the second circuit board 3, so as to improve service performance and working stability of the circuit board assembly.

More specifically, as shown in FIG. 5, the distance a1 between the first contact 211a and the tail end of the first connecting portion 311 is greater than or equal to 0.51 mm. For example, a1 may be specifically between 0.51 mm and 1.0 mm.

In this embodiment, it is set that the distance a1 between the first contact 211a and the tail end of the first connecting portion 311 is greater than 0.51 mm, so that the first contact 211a is connected to the first connecting portion 311 in a relatively large range, to improve stability of the electrical connection between the first contact 211a and the first connecting portion 311, and improve working stability of the second circuit board 3. In addition, the distance a1 between the first contact 211a and the tail end of the first connecting portion 311 is greater than 0.51 mm, and therefore when a processing error and an assembly error of the connector 2 and the second circuit board 3 are not considered, the reliability of the connection between the first contact 211a and the first connecting portion 311 is improved, and accordingly a requirement on precision of a processing size of a part such as the connector 2 and the second circuit board 3 is lowered, and processing difficulty is reduced, to reduce manufacturing costs.

Because a3=a1+a4, to increase a1, a4 needs to be decreased as much as possible, in other words, the distance between the tail end of the first connecting portion 311 and the tail end of the second circuit board 3 needs to be decreased as much as possible.

When a1=0.51 mm, the first contact 211a is more stably connected to the first connecting portion 311.

Specifically, as shown in FIG. 4, FIG. 5, and FIG. 6, a distance between a tail end of the first connecting portion 311 and a tail end of the second circuit board 3 is a4, and a4≤0.2 mm. For example, a4 may be specifically 0.15 mm, 0.1 mm, or 0.05 mm.

In this embodiment, a3=a1+a4, and a4≤0.2 mm, and therefore a distance a1 between a first contact 211a and the tail end of the first connecting portion 311 can be increased, to improve reliability of connection between the first contact 211a and the first connecting portion 311, and reduce a risk that the first contact 211a cannot be connected to the first connecting portion 311 in a mounting or transportation process, so as to improve service performance of the second circuit board 3. In this way, service performance and working stability of the circuit board assembly are improved.

More specifically, as shown in FIG. 4, a tail end of the first connecting portion 311 is flush with the side surface 32.

In this embodiment, the first connecting portion 311 is flush with the side surface 32, in other words, a distance between the tail end of the first connecting portion 311 and a tail end of the second circuit board 3 is a4=0. When a3 is a fixed value, a1 has a largest value in this case, in other words, a first contact 211a is connected to the tail end of the first connecting portion 311 in a largest range, and therefore stability of connection between the connector 2 and the first connecting portion 311 is further improved, and an offset of the second circuit board 3 is increased. In this way, processing precision of a part such as the second circuit board 3 and the connector 2 is reduced, and manufacturing costs are reduced, to further improve user experience.

Specifically, as shown in FIG. 4, FIG. 5, and FIG. 6, the second circuit board 3 further includes a bottom surface 33 disposed opposite to the top surface 31. The bottom surface 33 is connected to the side surface 32 by using a first inclined surface 34. A second connecting portion 331 is disposed on the bottom surface 33, and the second connecting portion 331 is electrically connected to the connector 2.

In this embodiment, the second connecting portion 331 is disposed on the bottom surface 33 of the second circuit board 3, and the second connecting portion 331 is electrically connected to a second contact 212a on a second sidewall 212 of the slot 21, so that the bottom surface 33 of the second circuit board 3 is electrically connected to the connector 2, to facilitate mounting of another electronic element on the bottom surface 33 of the second circuit board 3, so as to improve working performance and service efficiency of the second circuit board 3, and improve user experience. In addition, in a processing of mounting the second circuit board 3, the first inclined surface 34 can play a guiding role, so that a risk that the second circuit board 3 or the connector 2 is damaged due to interference between the second circuit board 3 and the connector 2 is reduced, to improve strength of the second circuit board 3 and the connector 2, and prolong a service life of each of the second circuit board 3 and the connector 2, so as to improve service performance of the circuit board assembly and improve user experience.

More specifically, as shown in FIG. 5, in the connector 2, the first contact 211a and the second contact 212a are staggered from each other, the second contact 212a is located outside the first contact 211a, and the distance a1 between the first contact 211a and the tail end of the first connecting portion 311 is less than a distance a2 between the second contact 212a and a tail end of the second connecting portion 331. In other words, when a1>0.5 mm, a2>0.5 mm.

In this embodiment, a part of the second circuit board 3 can be obliquely inserted into the slot 21 from top to bottom. Therefore, when the second contact 212a is located outside the first contact 211a, the first connecting portion 311 can be electrically connected to the first contact 211a, and the second connecting portion 331 can be electrically connected to the second contact 212a. In addition, when the second contact 212a is located outside the first contact 211a, the distance a1 between the first contact 211a and the tail end of the first connecting portion 311 is less than the distance a2 between the second contact 212a and the tail end of the second connecting portion 331, in other words, the second contact 212a is connected to the second connecting portion 331 in a larger range. When the range in which the first contact 211a is connected to the first connecting portion 311 makes it difficult to disconnect the first contact 211a and the first connecting portion 311, it is more difficult to disconnect the second contact 212a and the second connecting portion 331. In this way, stability of connection between the second contact 212a and the second connecting portion 331 can be improved, to improve working stability and service performance of the second circuit board 3.

Specifically, as shown in FIG. 6, the connector 2 includes the slot 21, the slot 21 includes a second sidewall 212 disposed opposite to the first sidewall 211, and a second contact 212a is disposed on the second sidewall 212; and the second circuit board 3 further includes a bottom surface 33 disposed opposite to the top surface 31, a second connecting portion 331 is disposed on the bottom surface 33, and the second contact 212a is electrically connected to the second connecting portion 331. As shown in FIG. 3, a part of the second circuit board 3 can be obliquely inserted into the slot 21 from top to bottom, the distance between the first connecting portion 311 and the side surface 32 is a4, a distance between the second connecting portion 331 and the side surface 32 is a5, and a4≤a5.

In this embodiment, a part of the second circuit board 3 is obliquely inserted into the slot 21 from top to bottom, and therefore it is set that the distance a4 between the first connecting portion 311 and the side surface 32 is less than the distance a5 between the second connecting portion 331 and the side surface 32, so that the first connecting portion 311 can be electrically connected to the first contact 211a, and the second connecting portion 331 can be electrically connected to the second contact 212a, to improve reliability of connection between the second circuit board 3 and the connector 2. In addition, the distance a4 between the first connecting portion 311 and the side surface 32 is less than the distance a5 between the second connecting portion 331 and the side surface 32, so that a size of the second connecting portion 331 is less than a size of the first connecting portion 311 while the reliability of the connection between the second circuit board 3 and the connector 2 is improved, to reduce processing costs of the second connecting portion 331 and improve user experience.

In another embodiment, as shown in FIG. 7, the second circuit board 3 further includes a bottom surface 33 disposed opposite to the top surface 31, and the bottom surface 33 intersects and is perpendicular to the side surface 32; and a second connecting portion 331 connected to the connector 2 is disposed on the bottom surface 33, and the second connecting portion 331 extends towards the side surface 32.

In this embodiment, the bottom surface 33 intersects and is perpendicular to the side surface 32, so that an area of the bottom surface 33 is increased, to increase an area in which the second connecting portion 331 can be mounted, and facilitate mounting of the second connecting portion 331. In addition, the second connecting portion 331 extends towards the side surface 32, so that a size of the second connecting portion 331 is increased, and a distance a5 between a tail end of the second connecting portion 331 and the tail end of the second circuit board 3 is decreased, to increase a distance a2 between a second contact 212a and the tail end of the second connecting portion 331, in other words, to increase a range in which the connector 2 is electrically connected to the second connecting portion 331, and reduce a risk that the connector 2 is not in contact with the second connecting portion 331 due to the fact that a position of the second circuit board 3 deviates in a mounting or transportation process, so as to improve stability of connection between the connector 2 and the second connecting portion 331, and improve working stability of the second circuit board 3. In this way, working performance of the circuit board assembly is improved, and user experience is improved.

Specifically, as shown in FIG. 7, the tail end of the second connecting portion 331 is flush with the side surface 32.

In this embodiment, the second connecting portion 331 is flush with the side surface 32, in other words, the distance between the tail end of the second connecting portion 331 and the tail end of the second circuit board 3 is a5=0, so that the tail end of the second connecting portion 331 is connected to the second contact 212a in a largest range, to further improve the stability of the connection between the connector 2 and the second connecting portion 331, and increase an offset of the second circuit board 3. In this way, processing precision of a part such as the second circuit board 3 and the connector 2 is reduced, and therefore manufacturing costs are reduced, to further improve user experience.

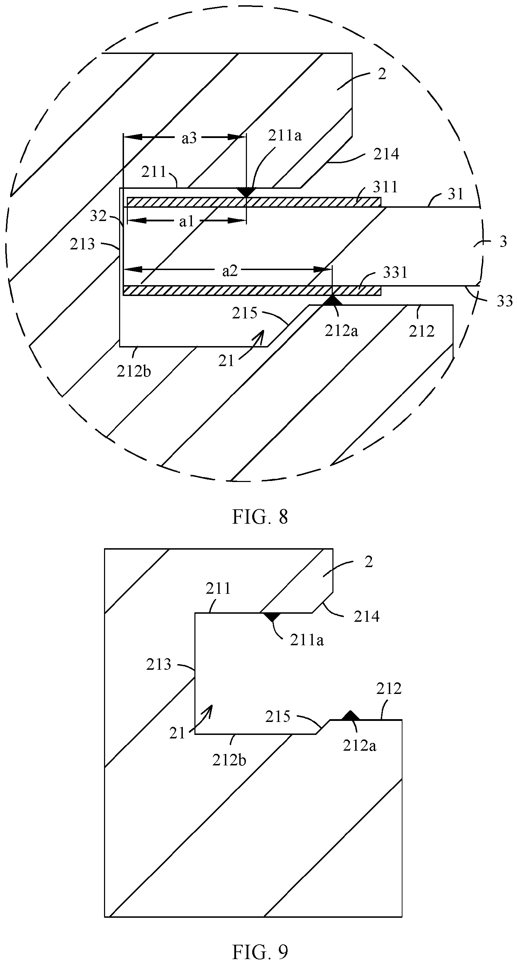

More specifically, as shown in FIG. 8, the tail end of the second connecting portion 331 is flush with the side surface 32, so that a distance a2 between the tail end of the second connecting portion 331 and the second contact 212a reaches a maximum value, to improve the stability of the connection between the connector 2 and the second connecting portion 331.

Specifically, as shown in FIG. 9, a concave portion 212b is disposed on the second sidewall 212.

In this embodiment, as shown in FIG. 3, in a process of mounting the second circuit board 3, after a part of the second circuit board 3 is obliquely inserted into the slot 21 from top to bottom, the top surface 31 of the second circuit board 3 is in contact with the first sidewall 211 of the slot 21, and the bottom surface 33 of the second circuit board 3 is in contact with the second sidewall 212 of the slot 21, to complete mounting of the second circuit board 3. Therefore, the concave portion 212b is disposed on the second sidewall 212, so that a risk that the second circuit board 3 cannot be mounted or is damaged due to interference between the second circuit board 3 and the second sidewall 212 can be reduced, to facilitate mounting of the second circuit board 3, improve accuracy of mounting the second circuit board 3, improve strength of the second circuit board 3 and the connector 2, and prolong a service life of each of the second circuit board 3 and the connector 2, so as to improve user experience.

Specifically, as shown in FIG. 9, a second inclined surface 214 and a third inclined surface 215 are disposed at an opening of the slot 21, and the second inclined surface 214 and the third inclined surface 215 are configured to guide a part of the second circuit board 3 into the slot 21.

In this embodiment, the second inclined surface 214 and the third inclined surface 215 play a guiding role, to facilitate insertion of the second circuit board 3 into the slot 21, simplify an operation of mounting the second circuit board 3, and improve the accuracy of mounting the second circuit board 3. In addition, the second inclined surface 214 and the third inclined surface 215 are disposed, so that there can be a lower probability that a problem such as a problem that the second circuit board 3 is scratched due to a sharp corner in the slot 21 in the mounting process occurs, to prolong a service life of the second circuit board 3.

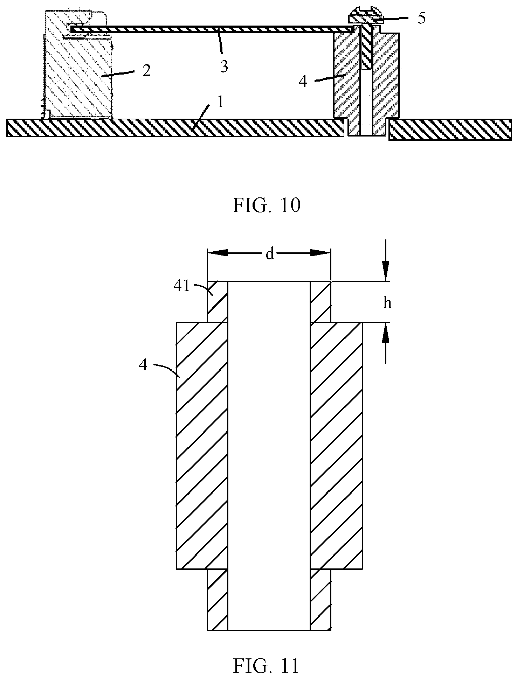

In any one of the foregoing embodiments, as shown in FIG. 10, an end that is of the second circuit board 3 and that is far away from the connector 2 is connected to the first circuit board 1 by using a stud 4.

In this embodiment, one end of the second circuit board 3 is connected to the connector 2, and the other end is connected to the stud 4, and the connector 2 and the stud 4 are used to restrict the second circuit board 3 to moving in a direction perpendicular to a thickness direction, to improve stability of mounting the second circuit board 3. In addition, because of a small size of the stud 4, space required for mounting the second circuit board 3 on the first circuit board 1 can be reduced, and therefore space of the first circuit board 1 is saved. In this way, utilization of the first circuit board 1 is improved, and therefore working performance of the first circuit board 1 is improved, and user experience is improved. As shown in FIG. 10, the end that is of the second circuit board 3 and that is far away from the connector 2 is connected to a fastener 5 by using the stud 4, so that a manner of connecting the second circuit board 3 and the stud 4 is simplified, to save the space of the first circuit board 1, so as to further improve the working performance of the first circuit board 1.

As shown in FIG. 10 and FIG. 11, a boss 41 is disposed on the stud 4. When the second circuit board 3 is mounted on the stud 4, the boss 41 plays a role of limiting a position of the second circuit board 3, to reduce a risk that the second circuit board 3 is separated from the stud 4 because the second circuit board 3 moves relative to the stud 4. A minimum thickness of the second circuit board 3 is 1.3 mm to 1.5 mm greater than a height h of the boss 41, so that a risk that the second circuit board 3 is unstably mounted due to an excessively large height h of the boss 41 is reduced, and a risk that it is difficult to mount the second circuit board 3 due to an excessively small height h of the boss 41 is reduced, to facilitate mounting of the second circuit board 3 and improve the stability of mounting the second circuit board 3. Specifically, the minimum thickness of the second circuit board 3 is 1.3 mm, 1.4 mm, or 1.5 mm greater than the height h of the boss 41. More preferably, the minimum thickness of the second circuit board 3 is 1.4 mm greater than the height h of the boss 41. In addition, a diameter of the boss 41 is d±0.03 mm. It is set that a tolerance of the diameter of the boss 41 is 0.03 mm, so that a risk that the second circuit board 3 is unstably mounted due to an excessively large diameter d of the boss 41 is reduced, and a risk that it is difficult to mount the second circuit board 3 due to an excessively small diameter d of the boss 41 is reduced, to further improve the stability of mounting the second circuit board 3.

Specifically, the stud 4 is attached to the first circuit board 1.

In this embodiment, the stud 4 is attached to the first circuit board 1, so that a manner of connecting the stud 4 and the first circuit board 1 can be simplified, and space required for mounting the stud 4 is reduced while stability of mounting the stud 4 is ensured, to further improve the utilization of the first circuit board 1 and improve the working performance of the first circuit board 1. In addition, the stud 4 is attached to the first circuit board 1, so that an operation in a process of mounting the stud 4 can be simplified, and a process required for mounting the stud 4 can be reduced, to reduce manufacturing costs of the circuit board assembly.

There is mounting precision of 0.01 when the stud 4 is attached to the first circuit board 1. If the mounting precision of the stud 4 is less than 0.01, difficulty of mounting the stud 4 is increased. If the mounting precision of the stud 4 is greater than 0.01, a risk that a position of the stud 4 deviates during mounting is increased. Therefore, when there is the mounting precision of 0.01 when the stud 4 is attached to the first circuit board 1, the difficulty of mounting the stud 4 can be decreased, and accuracy of mounting the stud 4 can be improved.

"Perpendicular" in the embodiments of this application includes a strict "perpendicular" case, that is, there is an angle of 90 degrees between two perpendicular planes, and further includes a basic "perpendicular" case, namely, another angle at which a corresponding effect can be achieved in engineering.

It should be noted that a part of the present patent application document includes content protected by the copyright. The copyright owner reserves the copyright except copies made for the patent documents or the recorded content of the patent documents in the Patent Office.

## Claims

1. A circuit board assembly, wherein the circuit board assembly comprises:
a first circuit board, wherein the first circuit board is connected to a connector; and
a second circuit board, wherein a first connecting portion is disposed on the second circuit board, and the first connecting portion is electrically connected to the connector, wherein
the second circuit board comprises a top surface and a side surface, and the top surface intersects and is perpendicular to the side surface; and
the first connecting portion is disposed on the top surface, and extends towards the side surface.

2. The circuit board assembly according to claim 1, wherein the connector comprises a slot, and a part of the second circuit board can be inserted into the slot;
the slot comprises a first sidewall, a first contact is disposed on the first sidewall, and the first contact is electrically connected to the first connecting portion; and
a distance between the first contact and a tail end of the first connecting portion is a1, and a1>0.

3. The circuit board assembly according to claim 2, wherein a1 ≥ 0.51 mm.

4. The circuit board assembly according to claim 1, wherein a distance between a tail end of the first connecting portion and the side surface is a4, and a4 ≤ 0.2 mm.

5. The circuit board assembly according to claim 1, wherein a tail end of the first connecting portion is flush with the side surface.

6. The circuit board assembly according to any one of claims 1 to 5, wherein the second circuit board further comprises a bottom surface disposed opposite to the top surface, and the bottom surface is connected to the side surface by using a first inclined surface; and
a second connecting portion is disposed on the bottom surface, and the second connecting portion is electrically connected to the connector.

7. The circuit board assembly according to any one of claims 1 to 5, wherein the second circuit board further comprises a bottom surface disposed opposite to the top surface, and the bottom surface intersects and is perpendicular to the side surface; and
a second connecting portion connected to the connector is disposed on the bottom surface, and the second connecting portion extends towards the side surface.

8. The circuit board assembly according to claim 7, wherein a tail end of the second connecting portion is flush with the side surface.

9. The circuit board assembly according to any one of claims 1 to 5, wherein the connector comprises the slot, the slot comprises the first sidewall and a second sidewall that are disposed opposite to each other, the first contact is disposed on the first sidewall, and a second contact is disposed on the second sidewall;
the second circuit board further comprises a bottom surface disposed opposite to the top surface, a second connecting portion is disposed on the bottom surface, the first contact is electrically connected to the first connecting portion, and the second contact is electrically connected to the second connecting portion; and
a part of the second circuit board can be obliquely inserted into the slot from top to bottom, the distance between the tail end of the first connecting portion and the side surface is a4, a distance between a tail end of the second connecting portion and the side surface is a5, and a4≤a5.

10. The circuit board assembly according to claim 9, wherein the second contact is located outside the first contact, the distance between the first contact and the tail end of the first connecting portion is a1, a distance between the second contact and the tail end of the second connecting portion is a2, and a1 ≤ a2.

11. The circuit board assembly according to claim 9, wherein a concave portion is disposed on the second sidewall.

12. The circuit board assembly according to claim 9, wherein a second inclined surface and a third inclined surface are disposed at an opening of the slot, and the second inclined surface and the third inclined surface are configured to guide a part of the second circuit board into the slot.

13. The circuit board assembly according to any one of claims 1 to 5, wherein an end that is of the second circuit board and that is far away from the connector is connected to the first circuit board by using a stud.

14. The circuit board assembly according to claim 13, wherein the stud is attached to the first circuit board.
